# EUROPÄISCHE PATENTSCHRIFT

(11) **EP 1 776 424 B1**
(45) Veröffentlichungstag und Bekanntmachung des Hinweises auf die Patenterteilung: **02.07.2008**
(21) Anmeldenummer: 05763398.4
(22) Anmeldetag: 08.07.2005
(51) Int. Cl.: C09C 1/36

(54) **VERFAHREN ZUR NACHBEHANDLUNG VON TITANDIOXID-PIGMENTEN**
METHOD FOR POST-TREATING TITANIUM DIOXIDE PIGMENTS
PROCEDE POUR LE POST-TRAITEMENT DE PIGMENTS DE DIOXYDE DE TITANE

(30) Priorität: 31.07.2004 DE 102004037272
(43) Veröffentlichungstag der Anmeldung: 25.04.2007
(73) Patentinhaber: KRONOS INTERNATIONAL, INC., 51307 Leverkusen (DE)
(72) Erfinder: BLUEMEL, Siegfried, 40883 Ratingen (DE); DREWS-NICOLAI, Lydia, 51057 Köln (DE)
(86) Internationale Anmeldenummer: PCT/EP2005/007387
(87) Internationale Veröffentlichungsnummer: WO 2006/012969

(56) Entgegenhaltungen:
- EP-A- 1 541 638
- GB-A- 1 365 999
- US-A- 4 405 376
- US-A- 4 450 012
- DATABASE WPI Section Ch, Week 199602 Derwent Publications Ltd., London, GB; Class E32, AN 1996-017430 XP002349392 & JP 07 292277 A (SAKAI KAGAKU KOGYO KK) 7. November 1995 (1995-11-07)

## Beschreibung

Die Erfindung betrifft ein Verfahren zur Nachbehandlung von Titandioxid-Pigmenten, solchermaßen hergestellte Titandioxid-Pigmente und ihre Verwendung in Farben, Lacken, und Kunststoffen.

Bei der Verwendung von TiO₂ als Weißpigment in Farben und Lacken, Kunststoffen usw. ist bekannt, dass durch UV-Absorption erzeugte unerwünschte photokatalytische Reaktionen zur Zersetzung des pigmentierten Materials führen.
Dabei absorbieren TiO₂-Pigmente im nahen ultravioletten Bereich Licht, so dass Elektron-Loch-Paare entstehen, welche hochreaktive Radikale auf der TiO₂-Oberfläche erzeugen. Die gebildeten Radikale haben in organischen Medien einen Bindemittelabbau zur Folge. Es ist bekannt, dass die Photoaktivität von TiO₂ erniedrigt werden kann, indem die TiO₂-Teilchen anorganisch nachbehandelt werden, z.B. mit Oxiden von Si und/oder AI und/oder Zr. Ferner ist bekannt, dass sich die Photoaktivität wie auch andere Pigmenteigenschaften beispielsweise durch den Einsatz von Sn-Verbindungen verbessern lassen.

Einige Beispiele für Sn als einem Bestandteil der Nachbehandlung von TiO₂-Pigmenten sind in den Patenten JP 61 141 616 und JP 61 286 221 gegeben, welche die Herstellung von leitfähigen Schichten auf TiO₂ beschreiben, die durch eine Kombination einer Zinn- und einer Antimon-Beschichtung hergestellt werden.
Die Patente DE 29 51 805 C2 und US 3,316,204 beschreiben die Herstellung von Laminatpigmenten, wobei Patent DE 29 51 805 C2 ein Laminatpigment mit einer Beschichtung aus Ce- und Al-Phosphat sowie einer äußeren Schicht aus einer Fluorid-Verbindung beschreibt, welche u.a. ein Sn-Fluorid sein kann. Das Patent US 3,316,204 beschreibt eine Beschichtung aus Sn- und Al-Oxid, wobei die hergestellten Pigmente anschließend bei Temperaturen über 625°C calciniert werden, um eine besondere Widerstandsfähigkeit gegen UV-Strahlung beim Einsatz im Laminatbereich zu erhalten. Ferner beschreiben die Patente JP 58 134 158 und US 4,405,376 (DE 31 45 620 C3) Pigmente mit verbesserter Dispergierbarkeit, gutem Glanz und guter Stabilität, die insbesondere für den Lackbereich geeignet sind. Darunter beschreibt das Patent JP 58 134 158 eine Beschichtung aus Sn-Phosphat und Aluminium-Oxid-Hydrat.
An dieser Stelle und im folgenden wird unter dem auf die Partikeloberfläche gefällten Oxid immer auch das jeweilige wasserhaltige Oxid (Oxidhydrat) verstanden.
Die US 4,405,376 (DE 31 45 620 C3) offenbart Pigmente mit einer inneren Schicht aus Sn- und Zr-Oxid sowie einer äußeren Schicht aus Al-Oxid. Das Aufbringen der inneren Schicht aus Sn- und Zr-Oxid wird dadurch bewerkstelligt, dass entweder nach Zugabe der Zr- und Sn-Verbindung bei einem pH-Wert von 2 mit NaOH neutralisiert wird oder nach Zugabe der Zr-Verbindung bei einem pH-Wert von 10 bis 10,5 eine saure Sn-Verbindung zugegeben wird. Im Anschluss daran wird auf die innere Sn-Zr-Oxid-Schicht eine äußere Al-Oxid-Schicht aufgebracht. Die nach oben beschriebenem Patent hergestellten Pigmente weisen einen hohen Glanz, eine gute Dispergierbarkeit und eine hohe Photostabilität (Kreidungsresistenz) auf. Gleichzeitig zeigen die Pigmente jedoch eine unerwünschte Gelbverfärbung.

Die Aufgabe der vorliegenden Erfindung ist es, ein Verfahren bereitzustellen, mit dem Titandioxid-Pigmente hergestellt werden können, die gegenüber dem Stand der Technik eine weiter verbesserte Photostabilität (Kreidungsresistenz) aufweisen unter Beibehaltung guter optischer Eigenschaften.

Die Aufgabe wird durch ein Verfahren zur Nachbehandlung von Titandioxid gelöst, das folgende Schritte aufweist:
a) Herstellen einer wässrigen Suspension von Titandioxid-Grundkörper mit einem pH-Wert von höchstens 3 oder einem pH-Wert von mindestens 10,
b) Zugabe wasserlöslicher Verbindungen von Zinn und Zirkon sowie von wasserlöslichen Verbindungen mindestens eines weiteren Elements aus der Gruppe Aluminium, Silicium und Titan, wobei der pH-Wert von 3 nicht überschritten bzw. der pH-Wert von 10 nicht unterschritten wird,
c) Einstellen des pH-Werts der Suspension auf 6 bis 8.
Weitere vorteilhafte Ausgestaltungen der Erfindung sind in den Unteransprüchen beschrieben.

Im Gegensatz zu dem Verfahren gemäß US 4,405,376 (DE 31 45 620 C3), das infolge einer zwischengeschalteten Neutralisation der Suspension getrennte Schichten von Zr-/Sn-Oxid und Al-Oxid erzeugt, zeichnet sich das erfindungsgemäße Verfahren dadurch aus, dass erst ein neutraler pH-Wert von 6 bis 8 eingestellt wird, wenn alle Komponenten - Sn, Zr und mindestens eine weitere aus der Gruppe Al, Si und Ti - der Suspension zugegeben worden sind. Überraschenderweise führt die erfindungsgemäße Verfahrensführung zu einer deutlich verbesserten Witterungsstabilität der TiO₂-Pigmente.
Anschließend können weitere Schichten aufgefällt werden, z.B. eine abschließende Al-Oxid-Schicht zur Verbesserung des Deckvermögens.

Das Ausgangs-Titandioxidpigment ist ein Grundkörper, der nach dem bekannten Sulfat- oder Chloridverfahren hergestellt wird, und liegt entweder in Anatas- oder in Rutilform vor. Insbesondere der nach dem Sulfatverfahren hergestellte Grundkörper sollte vorzugsweise in bekannter Weise durch Glühzusätze wie Kalium, Aluminium, Phosphor, Lithium und dergleichen stabilisiert sein. Das erfindungsgemäße Verfahren kann ausgehend von einer wässrigen Titandioxid-Grundkörper-Suspension sowohl mit stark saurem pH-Wert von höchstens 3 bevorzugt höchstens 2 wie mit stark alkalischem pH-Wert von mindestens 10 bevorzugt mindestens 11 durchgeführt werden (Schritt a).
Während des folgenden Schritts (b) werden der Suspension wässrige Lösungen der Nachbehandlungskomponenten Sn, Zr und mindestens einer weiteren aus der Gruppe Al, Si und Ti zugegeben. Während der Zugabe bleibt der pH-Wert der Suspension in dem in Schritt (a) spezifizierten Bereich, d.h. bei höchstens 3 bevorzugt höchstens 2 bzw. bei mindestens 10 bevorzugt mindestens 11. Nach jeder Zugabe kann eine Retentionszeit von 15 bis 30 Minuten erfolgen.
Anschließend wird in einem Schritt (c) die Suspension auf einen pH-Wert von 6 bis 8 durch Zugabe entweder alkalischer bzw. saurer Verbindungen eingestellt.
Hieran kann sich die Auffällung weiterer Schichten anschließen, wie z.B. die Auffällung einer abschließenden Al₂O₃-Schicht.

Bei Behandlungen, die im sauren pH-Wertbereich beginnen, werden zunächst wässrige Sn- und Zr-Salzlösungen sowie mindestens eine weitere Komponente - Al- und/oder Ti- und/oder Si-Verbindungen - zugegeben (Schritt b). Wichtig hierbei ist, dass während der Zugabe aller Komponenten der pH-Wert höchsten 3 beträgt. Bevorzugt werden daher saure Sn- bzw. Zr-Salzlösungen eingesetzt. Alternativ können auch alkalische Lösungen eingesetzt werden, wobei in diesem Fall durch die parallele Zuführung von Säure dafür gesorgt werden muss, dass der pH-Wert 3 nicht überschreitet. Dem Fachmann sind geeignete Substanzen und die erforderlichen Mengen zur Steuerung bekannt. Die Reihenfolge der Zugabe ist im Sinne der Erfindung unerheblich.
Die anschließende Anhebung des pH-Werts in den neutralen Bereich 6 bis 8 (Schritt c) wird mit einer Lauge wie z.B. NaOH oder einer alkalischen Verbindung, gegebenenfalls in Verbindung mit einer Lauge, vorgenommen. Insbesondere können auch alkalische Verbindungen verwendet werden, die bereits in Schritt (b) eingesetzt werden (z.B. Natriumaluminat oder Natriumsilikat).
Optional wird zwischen Schritt (b) (Zugaben im pH-Wertbereich von höchstens 3) und Schritt (c) (Anhebung des pH-Werts) eine Rührzeit zur Homogenisierung eingeführt.

Bei Fällung aus dem alkalischen Bereich heraus ist die Reihenfolge der Zugabe der Komponenten ebenfalls variabel. Zunächst werden bei einem pH-Wert von mindestens 10 bevorzugt mindestens 11 die Behandlungskomponenten - wässrige Lösungen von Sn und
Zr sowie von Al und/oder Si und/oder Ti - in die Suspension gegeben (Schritt b). Währenddessen wird der pH-Wert auf mindestens 10 bevorzugt mindestens 11 gehalten, z. B. durch parallele Zugabe von Lauge wie NaOH. Dem Fachmann sind geeignete Substanzen und die erforderlichen Mengen zur Steuerung bekannt Beispielsweise werden zunächst die wasserlösliche alkalische Al-Verbindung und/oder die alkalische Si-Verbindung und anschließend die wässrigen Lösungen der Sn- und Zr-Komponenten sowie gegebenenfalls der Ti-Komponente in die Suspension gegeben.
Die anschließende Senkung des pH-Werts in den neutralen Bereich von 6 bis 8 (Schritt c) wird mit einer Säure wie z.B. HCl oder einer sauren Verbindung, gegebenenfalls in Verbindung mit einer Säure wie HCl vorgenommen. Insbesondere können auch saure Verbindungen verwendet werden, die bereits in Schritt (b) eingesetzt werden (z.B. saure Sn- oder Zr-Verbindungen oder Aluminiumsulfat).

In den beschriebenen und allen anderen Ausführungsformen des erfindungsgemäßen Verfahrens können beispielsweise folgende wasserlösliche Verbindungen als Nachbehandlungskomponenten eingesetzt werden, wobei diese Aufzählung jedoch nicht als erschöpfend anzusehen ist:
Als saure Zinnverbindungen kommen sauer reagierende Zinnsalze sowohl des zwei- wie des vierwertigen Zinns in Frage, beispielsweise Zinn(II)chlorid oder Zinn(II)sulfat. Als alkalische Zinnverbindungen stehen z.B. Natrium- oder Kaliumstannat zur Verfügung.
Als saure Zirkonverbindungen sind beispielsweise Zirkonsulfat, Zirkonoxychlorid oder Zirkonnitrat geeignet. Die alkalische Zirkonverbindung kann beispielsweise aus der Gruppe der Zirkoncarbonatkomplexe ausgewählt werden.
Als alkalische Aluminiumverbindung sind Alkalialuminate, insbesondere Natriumaluminat geeignet. Als sauer reagierende Aluminiumverbindungen kommen Aluminiumsulfat oder Aluminiumchlorid in Frage.
Als alkalische Siliciumverbindungen werden bevorzugt Alkalisilikate, insbesondere Natriumsilikat (Wasserglas) verwendet.
Geeignete Titanverbindungen sind Titanylverbindungen wie Titanylsulfat oder Titanylchlorid.

Die Mengen der in Schritt (b) eingesetzten Nachbehandlungskomponenten gerechnet als ihre Oxide und bezogen auf den TiO₂-Grundkörper sind dabei wie folgt:
0,1 bis 1,0 Gew.-% SnO₂, bevorzugt 0,2 bis 0,5 Gew.-%;
0,1 bis 1,5 Gew.-% ZrO₂, bevorzugt 0,2 bis 1,0 Gew.-%;
0,1 bis 1,5 Gew.-% SiO₂, bevorzugt 0,2 bis 1,0 Gew.-%;
0,1 bis 1,0 Gew.-% TiO₂;
01, bis 3,0 Gew.-% Al₂O₃, bevorzugt 0,2 bis 1,5 Gew.-%.

Auf die gemäß oben beschriebenem Verfahren beschichteten TiO₂-Partikel kann anschließend durch bekannte Nachbehandlungsverfahren eine Al-Oxid-Schicht in variablen Mengen, bevorzugt bis zu 6,0 Gew.-% gerechnet als Al₂O₃ und bezogen auf den TiO₂-Grundkörper, aufgebracht werden.

Die abschließende Behandlung der TiO₂-Suspension erfolgt nach dem Fachmann bekannten Verfahren. Beispielsweise wird die Suspension auf einen End-pH-Wert von etwa 7 eingestellt. Bevorzugt wird der End-pH-Wert auf einen Wert von mindestens 7 und insbesondere auf einen Wert von mindestens 7,5 eingestellt. Hierdurch werden verbesserte optische Werte, insbesondere ein verbesserter Farbton b erzielt. Insbesondere bei der besonderen Verfahrensführung, die im alkalischen Bereich bei einem pH-Wert von mindestens 10 startet, wird eine Optimierung des Farbtons b durch die Einstellung des End-pH-Werts auf mindestens 7 bevorzugt mindestens 7,5 erzielt. Anschließend wird das Pigment durch Waschen von den wasserlöslichen Salzen befreit. Die Trocknung erfolgt üblicherweise bei etwa 110 bis 160°C. Abschließend wird das Pigment gemahlen.

Es ist bekannt, dass höhere Zinngehalte in der Beschichtung zur einer Verfärbung des Titandioxidpigments führen können, insbesondere zu einer Erhöhung des Farbtons b. Mit einer Temperung der erfindungsgemäß nachbehandelten Pigmente bei Temperaturen über 125 °C bis zu 500 °C, bevorzugt bei etwa 160 °C und insbesondere bei etwa 250 °C kann der Farbton b deutlich verbessert werden, ohne dass die Stabilität beeinträchtigt wird.

Die gemäß der Erfindung hergestellten Pigmente zeigen somit gegenüber den Vergleichspigmenten eine verbesserte Photostabilität (Kreidungsresistenz) und darüber hinaus nach Temperung verbesserte optische Eigenschaften (Helligkeit und Farbton). Sie sind besonders geeignet zur Pigmentierung von Kunststoffen, Farben und Lacken.

### Beispiele

Nachfolgend wird die Erfindung anhand einiger Beispiele erläutert, die jedoch nicht als Einschränkung zu verstehen sind. Die Mengenangaben in Gew.-% beziehen sich jeweils auf den TiO₂-Grundkörper. Auf jede Zugabe folgt eine Rührzeit von etwa 15 bis 30 Minuten.

### Beispiel 1

Eine sandgemahlene Suspension aus Ti02-Grundkörper hergestellt nach dem Chloridprozess mit einer TiO₂-Konzentration von 450g/l wird bei 60°C mit HCl auf einen pH-Wert von 2 eingestellt. Unter Rühren werden der Suspension 0,5 Gew.-% SnO₂ als Zinn(II)chlorid-Lösung und danach 0,5 Gew.-% ZrO₂ als Zirkonoxychlorid zugefügt. Unter Rühren wird 0,3 Gew.-% Al₂O₃ als Natriumaluminat zugegeben und anschließend der pH-Wert durch weitere Zugabe von Natriumaluminat auf etwa 7 eingestellt.
In Form eines fixed-pH-Verfahrens wird Al₂O₃ - zugegeben als Natriumaluminat - bei einem pH-Wert von 7 bis 8 gegen HCl gefällt, so dass die Gesamtmenge an Al₂O₃ 3,0 Gew.-% beträgt.
Abschließend wird die Suspension durch Waschen von den wasserlöslichen Salzen befreit, 16 Stunden bei 160°C bzw. bei 250°C getrocknet und anschließend gemahlen.
Die Kreidungsresistenz des Pigments liegt bei 100 %. Der Farbton b liegt nach Trocknung bei 160°C bei 0,4 und nach Trocknung bei 250°C bei 0,3.

### Beispiel 2

Eine sandgemahlene Suspension aus TiO₂-Grundkörper hergestellt nach dem Chloridprozess mit einer TiO₂-Konzentration von 450 g/l wird bei 60°C mit HCl auf einen pH-Wert von 2 eingestellt. Unter Rühren wird der Suspension 0,5% SnO₂ als Zinn(II)chlorid-Lösung zugefügt. Anschließend werden der Suspension 0,5 Gew.-% ZrO₂ als Zirkonsulfat und im nächsten Schritt 0,5 Gew.-% SiO₂ als Na-Wasserglas zugefügt. Der pH-Wert liegt bei etwa 1,4. Anschließend werden 2,6 Gew.-% Al₂O₃ als Natriumaluminat und 0,4 Gew.-% Al₂O₃ als Aluminiumsulfat zugegeben.
Die Suspension wird abschließend auf einen pH-Wert von 7 eingestellt und durch Waschen von den wasserlöslichen Salzen befreit, getrocknet und gemahlen.
Die Kreidungsresistenz des Pigments liegt bei 111 %.

### Beispiel 3

Eine sandgemahlene Suspension aus TiO₂-Grundkörper hergestellt nach dem Chloridprozess mit einer TiO₂-Konzentration von 450g/l wird bei 60°C mit HCl auf einen pH-Wert von 2 eingestellt. Unter Rühren wird der Suspension 0,5 Gew.-% SnO₂ als Zinn(II)chlorid-Lösung zugefügt. Anschließend werden der Suspension 0,5 Gew.-% ZrO₂ als Zirkonsulfat und dananch 0,2 Gew.-% TiO₂ als Titanylchlorid zugefügt. Im nächsten Schritt wird der Suspension 0,3 Gew.-% SiO₂ als Na-Wasserglas zugefügt. Nachfolgend wird 0,3 Gew.-% Al₂O₃ als Natriumaluminat zugegeben und anschließend der pH-Wert durch weitere Zugabe von Natriumaluminat auf einen Wert von 8 eingestellt.
Anschließend wird Al₂O₃- zugegeben als Natriumaluminat - in Form eines fixed-pH-Verfahrens gegen HCl bei einem pH-Wert von 7 bis 8 gefällt, so dass die Gesamtmenge an Al₂O₃ 3,0 Gew.-% beträgt.
Die Suspension wird abschließend auf einen pH-Wert von 7 eingestellt und durch Waschen von den wasserlöslichen Salzen befreit, 16 Stunden bei 160°C bzw. bei 250°C getrocknet und gemahlen.
Die Kreidungsresistenz des Pigments liegt bei 111 %. Der Farbton b liegt nach Trocknung bei 160°C bei 0,5 und nach Trocknung bei 250°C bei 0,3.

### Beispiel 4

Eine sandgemahlene Suspension aus TiO₂-Grundkörper hergestellt nach dem Chloridprozess mit einer TiO₂-Konzentration von 450g/l wird bei 60°C mit NaOH auf einen pH-Wert von 11 eingestellt. Unter Rühren wird der Suspension 0,5 Gew.-% ZrO₂ als Zirkonoxychlorid zugefügt. Der pH-Wert der Suspension wird mit NaOH auf 11 stabilisiert. Der Suspension werden im nächsten Schritt 0,5 Gew.-% SiO₂ als Na-Wasserglas und anschließend 0,5 Gew.-% SnO₂ als SnCl₂ zugefügt. Anschließend wird der pH-Wert mit HCl auf 7 bis 8 eingestellt.
Nachfolgend wird 3,0 Gew.-% Al₂O₃ - zugegeben in Form von Natriumaluminat - bei einem festen pH-Wert von 7 bis 8 gegen HCl gefällt.
Abschließend wird die Suspension auf einen pH-Wert von 7 eingestellt, durch Waschen von den wasserlöslichen Salzen befreit, 16 Stunden bei 160°C bzw. bei 250°C getrocknet und anschließend gemahlen.
Die Kreidungsresistenz des Pigments liegt bei 90 %. Der Farbton b liegt nach Trocknung bei 160°C bei 0,5 und nach Trocknung bei 250°C bei 0,3.

### Vergleichsbeispiel A

Eine sandgemahlene Suspension aus TiO₂-Grundkörper hergestellt nach dem Chloridprozess mit einer TiO₂-Konzentration von 450g/l wird bei 60°C mit HCl auf einen pH-Wert von 2 eingestellt. Unter Rühren werden der Suspension 0,5 Gew.-% SnO₂ als Zinn(II)chlorid-Lösung und danach 0,5 Gew.-% ZrO₂ als Zirkonsulfat zugefügt. Die Suspension wird im nächsten Schritt durch Zugabe von NaOH auf einen pH von 8 eingestellt.
Es wird anschließend Al₂O₃ in Form einer parallelen Zugabe von Natriumaluminat und HCl bei einem festen pH-Wert von 7 bis 8 zugemischt, so dass die Gesamtmenge an Al₂O₃ 3,0 Gew.-% beträgt.
Abschließend wird die Suspension durch Waschen von den wasserlöslichen Salzen befreit, 16 Stunden bei 160°C getrocknet und gemahlen.
Die Kreidungsresistenz des Pigments liegt bei 83 %. Der Farbton b beträgt nach Trocknung bei 160°C 0,5.

### Vergleichbeispiel B

Vergleichsbeispiel B entspricht Beispiel 4 ohne Zugabe von SiO₂:
Eine sandgemahlene Suspension aus TiO₂-Grundkörper hergestellt nach dem Chloridprozess mit einer TiO₂-Konzentration von 450g/l wird bei 60°C mit NaOH auf einen pH-Wert von 11 eingestellt. Unter Rühren wird der Suspension 0,5 Gew.-% ZrO₂ als Zirkonoxychlorid zugefügt. Der pH-Wert der Suspension wird mit NaOH auf 11 stabilisiert. Anschließend wird 0,5 Gew.-% SnO₂ als SnCl₂ zugefügt.
Nachfolgend wird 3,0 Gew.-% Al₂O₃ - zugegeben in Form von Natriumaluminat - bei einem festen pH-Wert von 7 bis 8 gegen HCl gefällt.
Abschließend wird die Suspension auf einen pH-Wert von 7 eingestellt, durch Waschen von den wasserlöslichen Salzen befreit, 16 Stunden bei160°C bzw. bei 250°C getrocknet und anschließend gemahlen.
Die Kreidungsresistenz des Pigments liegt bei 83 %. Der Farbton b beträgt nach Trocknung bei 160°C 0,5. Testung

Die Photostabilität der hergestellten Beispiel- und Vergleichsbeispiel-Pigmente wird in einem Alkydharz-Lacksystem getestet, das einer Kurzbewitterung ausgesetzt war. Die Bewitterung findet in einem sogenannten Weather-Ometer (WOM), einem Bewitterungsgerät statt, das aus einer belüfteten Prüfkammer besteht mit
a.) Strahlungsquelle (Kohleelektroden, die im Betrieb einen Lichtbogen erzeugen)
b.) Strahlungsfilter aus Spezialglas
c.) Vorrichtung zur Probenberieselung mit Wasser
d.) Zerstäuber zur Erzeugung von Luftfeuchtigkeit
e.) drehbarem Probenhalter
Während des Testzyklus wird eine Freibewitterung zeitraffend simuliert. Innerhalb der Testzeit verwittert der Lack. Parallel wird die Kreidungsresistenz untersucht. Bei jedem Testzyklus wird zusätzlich ein Vergleichspigment als Standard eingesetzt.
Die Messung der Kreidung erfolgt gemäß DIN 53159. Dabei wird auf die kreidende Lackoberfläche ein schwarzes eingeweichtes Photopaper gedrückt. Als Kreidungsbeginn (Kreidungsresistenz) gilt der Tag, an dem Pigment- und Füllstoffpartikei einen vollständigen weißen Abdruck hinterlassen. Die Kreidungsresistenz wird in Prozent bezogen auf den Standard angegeben.

Die Bestimmung der optischen Eigenschaften, insbesondere des Farbtons b, erfolgte in Anlehnung an DIN 5033 über die Bestimmung von Helligkeit L*, Farbton a* und Farbton b* von Titandioxid-Pigmenten in lack- und lösemittelfreien Pulverpresslingen. Der Pulverpressling wird unter definierten Bedingungen aus dem zu testenden Pigment hergestellt. Mit einem HUNTERLAB-Colorimeter werden die Remissionswerte bestimmt.

### Testergebnisse

Es zeigt sich, dass die erfindungsgemäße Verfahrensführung gegenüber der aus dem Stand der Technik (DE 31 45 620 C3) bekannten, bei der eine separate Zr-Sn-Oxid-Schicht aufgefällt wird, zu einer deutlich verbesserten Photostabilität (Kreidungsresistenz) des TiO₂-Pigments führt. Dies gilt für die Behandlung im sauren Bereich (Beispiele 1, 2 und 3 / Vergleichsbeispiel A) wie im alkalischen Bereich (Beispiel 4 / Vergleichsbeispiel B).

Die Ergebnisse für die Beispielspigmente 1, 3 und 4 zeigen außerdem, dass der Farbton b des mit Sn-Oxid behandelten TiO₂-Pigments durch abschließende Temperung bei höheren Temperaturen (z.B. 250°C gegenüber 160°C) zu niedrigeren Werten verschoben werden kann.

## Patentansprüche

1. Verfahren zur Nachbehandlung von Titandioxid **gekennzeichnet durch** die Schritte
a) Herstellen einer wässrigen Suspension von Titandioxid-Grundkörper mit einem pH-Wert von höchstens 3 oder einem pH-Wert von mindestens 10,
b) Zugabe wasserlöslicher Verbindungen von Zinn und Zirkon sowie von wasserlöslichen Verbindungen mindestens eines weiteren Elements aus der Gruppe Aluminium, Silicium und Titan, wobei der pH-Wert von 3 nicht überschritten bzw. der pH-Wert von 10 nicht unterschritten wird,
c) Einstellen des pH-Werts der Suspension auf 6 bis 8.

2. Verfahren nach Anspruch 1 **dadurch gekennzeichnet,**
**dass** 0,1 bis 1,0 Gew.-% bevorzugt 0,2 bis 0,5 Gew.-% einer Zinn-Verbindung gerechnet als SnO₂ und bezogen auf den TiO₂-Grundkörper eingesetzt wird.

3. Verfahren nach Anspruch 1 **dadurch gekennzeichnet,**
**dass** 0,1 bis 1,5 Gew:-% bevorzugt 0,2 bis 1,0 Gew.-% einer Zirkon-Verbindung gerechnet als ZrO₂ und bezogen auf den TiO₂-Grundkörper eingesetzt wird.

4. Verfahren nach Anspruch 1 **dadurch gekennzeichnet,**
**dass** 0,1 bis 3,0 Gew.-% bevorzugt 0,2 bis 1,5 Gew.-% einer Aluminium-Verbindung gerechnet als Al₂O₃ und bezogen auf den TiO₂-Grundkörper eingesetzt wird.

5. Verfahren nach Anspruch 1 **dadurch gekennzeichnet,**
**dass** 0,1 bis 1,5 Gew:-% bevorzugt 0,2 bis 1,0 Gew.-% einer Silicium-Verbindung gerechnet als SiO₂ und bezogen auf den TiO₂-Grundkörpe eingesetzt wird.

6. Verfahren nach Anspruch 1 **dadurch gekennzeichnet,**
**dass** 0,1 bis 1,0 Gew:-% einer Titan-Verbindung gerechnet als TiO₂ und bezogen auf den TiO₂-Grundkörper eingesetzt werden.

7. Verfahren nach einem oder mehreren der Ansprüche 1 bis 6 **gekennzeichnet durch** Schritt
d) Auffällen einer äußeren Schicht aus wasserhaltigem Aluminiumoxid.

8. Verfahren nach Anspruch 7 **dadurch gekennzeichnet,**
**dass** nach Schritt d) der End-pH-Wert auf mindestens 7, bevorzugt auf mindestens 7,5 eingestellt wird.

9. Verfahren nach Anspruch 1 oder 2 **dadurch gekennzeichnet,**
**dass** die eingesetzte Zinn-Verbindung ausgewählt wird aus der Gruppe Zinn(II)chlorid, Zinn(II)sulfat, Kaliumstannant und Natriumstannat.

10. Verfahren nach Anspruch 1 oder 3 **dadurch gekennzeichnet,**
**dass** die eingesetzte Zirkon-Verbindung ausgewählt wird aus der Gruppe Zirkonsulfat, Zirkonoxychlorid, Zirkonnitrat und Zirkoncarbonat.

11. Verfahren nach Anspruch 1, 4 oder 7 **dadurch gekennzeichnet,**
**dass** die eingesetzten Aluminium-Verbindungen Alkalialuminate insbesondere Natriumaluminat oder saure Aluminum-Verbindungen insbesondere Aluminiumsulfat oder Aluminiumchlorid sind.

12. Verfahren nach Anspruch 1 oder 5 **dadurch gekennzeichnet,**
**dass** die eingesetzte Silicium-Verbindung ein Alkalisilikat insbesondere Natriumsilikat ist.

13. Verfahren nach Anspruch 1 oder 6 **dadurch gekennzeichnet,**
**dass** die eingesetzte Titan-Verbindung eine Titanylverbindung ist insbesondere Titanylsulfat oder Titanylchlorid.

14. Verfahren nach einem oder mehreren der Ansprüche 1 bis 13 **dadurch gekennzeichnet, dass**
in Schritt c) entweder eine Lauge bzw. Säure oder eine der in Schritt b) zugegebenen Verbindungen oder Mischungen davon zugegeben werden.

15. Verfahren nach einem oder mehreren der Ansprüche 1 bis 14 **dadurch gekennzeichnet,**
**dass** das Titandioxid abschließend bei Temperaturen über 125 °C bis zu 500°C bevorzugt bei etwa 160 °C und insbesondere bei etwa 250°C getempert wird.

## Claims

1. Method for the post-treatment of titanium dioxide, **characterised by** the steps:
a) Production of an aqueous suspension of titanium dioxide base material with a pH value of not more than 3, or a pH value of not less than 10,
b) Addition of water-soluble compounds of tin and zirconium, as well as water-soluble compounds of at least one further element from the group comprising aluminium, silicon and titanium, where the pH value does not exceed 3, or the pH value does not drop below 10,
c) Adjustment of the pH value of the suspension to between 6 and 8.

2. Method according to Claim 1, **characterised in that**
0.1 to 1.0% by weight, preferably 0.2 to 0.5% by weight, of a tin compound are used, calculated as SnO₂ and referred to the TiO₂ base material.

3. Method according to Claim 1, **characterised in that**
0.1 to 1.5% by weight, preferably 0.2 to 1.0% by weight, of a zirconium compound are used, calculated as ZrO₂ and referred to the TiO₂ base material.

4. Method according to Claim 1, **characterised in that**
0.1 to 3.0% by weight, preferably 0.2 to 1.5% by weight, of an aluminium compound are used, calculated as Al₂O₃ and referred to the TiO₂ base material.

5. Method according to Claim 1, **characterised in that**
0.1 to 1.5% by weight, preferably 0.2 to 1.0% by weight, of a silicon compound are used, calculated as SiO₂ and referred to the TiO₂ base material.

6. Method according to Claim 1, **characterised in that**
0.1 to 1.0% by weight of a titanium compound are used, calculated as TiO₂ and referred to the TiO₂ base material.

7. Method according to one or more of Claims 1 to 6, **characterised by** Step
d) Precipitation of an outer layer of aqueous aluminium oxide.

8. Method according to Claim 7, **characterised in that**
after Step d) the final pH value is set to no less than 7, preferably to no less than 7,5.

9. Method according to Claim 1 or 2, **characterised in that**
the tin compound used is selected from the group comprising stannous chloride, stannous sulphate, potassium stannate and sodium stannate.

10. Method according to Claim 1 or 3, **characterised in that**
the zirconium compound used is selected from the group comprising zirconium sulphate, zirconium oxychloride, zirconium nitrate and zirconium carbonate.

11. Method according to Claim 1, 4 or 7, **characterised in that**
the aluminium compounds used are alkali aluminates, particularly sodium aluminate, or acidic aluminium compounds, particularly aluminium sulphate or aluminium chloride.

12. Method according to Claim 1 or 5, **characterised in that**
the silicon compound used is an alkali silicate, particularly sodium silicate.

13. Method according to Claim 1 or 6, **characterised in that**
the titanium compound used is a titanyl compound, particularly titanyl sulphate or titanyl chloride.

14. Method according to one or more of Claims 1 to 13, **characterised in that**,
in Step c), either a lye or an acid is added, or one of the compounds added in Step b), or mixtures thereof.

15. Method according to one or more of Claims 1 to 14, **characterised in that**
the titanium dioxide is finally thermally treated at temperatures from over 125 °C to up to 500 °C, preferably at about 160 °C and particularly at about 250 °C.

## Revendications

1. Procédé pour le post-traitement de dioxyde de titane, **caractérisé par** les étapes suivantes:
a) préparation d'une suspension aqueuse d'un corps de base en dioxyde de titane avec une valeur de pH d'au plus 3 ou une valeur de pH d'au moins 10,
b) addition de composés d'étain et de zirconium solubles dans l'eau ainsi que de composés solubles dans l'eau d'au moins un autre élément du groupe aluminium, silicium et titane, sans dépasser vers le haut la valeur de pH de 3 ou vers le bas la valeur de pH de 10,
c) régler la valeur du pH de la suspension de 6 à 8.

2. Procédé selon la revendication 1, **caractérisé en ce que** l'on utilise 0,1 à 1,0% en poids, de préférence 0,2 à 0,5% en poids d'un composé d'étain calculé sous la forme SnO₂ et rapporté au corps de base en TiO₂.

3. Procédé selon la revendication 1, **caractérisé en ce que** l'on utilise 0,1 à 1,5% en poids, de préférence 0,2 à 1,0% en poids d'un composé de zirconium calculé sous la forme ZrO₂ et rapporté au corps de base en TiO₂.

4. Procédé selon la revendication 1, **caractérisé en ce que** l'on utilise 0,1 à 3,0% en poids, de préférence 0,2 à 1,5% en poids d'un composé d'aluminium calculé sous la forme Al₂O₃ et rapporté au corps de base en TiO₂.

5. Procédé selon la revendication 1, **caractérisé en ce que** l'on utilise 0,1 à 1,5% en poids, de préférence 0,2 à 1,0% en poids d'un composé de silicium calculé sous la forme SiO₂ et rapporté au corps de base en TiO₂.

6. Procédé selon la revendication 1, **caractérisé en ce que** l'on utilise 0,1 à 1,0% en poids d'un composé de titane calculé sous la forme TiO₂ et rapporté au corps de base en TiO₂.

7. Procédé selon une ou plusieurs des revendications 1 à 6, **caractérisé par** l'étape suivante:
d) précipitation d'une couche extérieure en oxyde d'aluminium hydraté.

8. Procédé selon la revendication 7, **caractérisé en ce qu'**après l'étape d), on règle la valeur du pH finale à au moins 7, de préférence à au moins 7,5.

9. Procédé selon la revendication 1 ou 2, **caractérisé en ce que** l'on sélectionne le composé d'étain utilisé dans le groupe chlorure d'étain(II), sulfate d'étain(II), stannate de potassium et stannate de sodium.

10. Procédé selon la revendication 1 ou 3, **caractérisé en ce que** l'on sélectionne le composé de zirconium utilisé dans le groupe sulfate de zirconium, oxychlorure de zirconium, nitrate de zirconium et carbonate de zirconium.

11. Procédé selon la revendication 1, 4 ou 7, **caractérisé en ce que** les composés d'aluminium utilisés sont des aluminates alcalins, en particulier l'aluminate de sodium, ou des composés acides d'aluminium, en particulier le sulfate d'aluminium ou le chlorure d'aluminium.

12. Procédé selon la revendication 1 ou 5, **caractérisé en ce que** le composé de silicium utilisé est un silicate alcalin, en particulier le silicate de sodium.

13. Procédé selon la revendication 1 ou 6, **caractérisé en ce que** le composé de titane utilisé est un composé de titanyle, en particulier du sulfate de titanyle ou du chlorure de titanyle.

14. Procédé selon une ou plusieurs des revendications 1 à 13, **caractérisé en ce qu'**à l'étape c), on ajoute soit une lessive ou un acide ou un des composés ajoutés à l'étape b) soit des mélanges de ceux-ci.

15. Procédé selon une ou plusieurs des revendications 1 à 14, **caractérisé en ce que** l'on chauffe finalement le dioxyde de titane à des températures supérieures à 125°C jusque 500°C, de préférence à environ 160°C et en particulier à environ 250°C.
